# EUROPEAN PATENT SPECIFICATION

(11) **EP 3 598 633 B1**
(45) Date of publication and mention of the grant of the patent: **24.04.2024**
(21) Application number: 19186207.7
(22) Date of filing: 15.07.2019
(51) Int. Cl.: H02P 23/14, H02P 21/14, H02P 29/00, B60L 3/12, B64C 39/02

(54) **PERFORMANCE MONITORING SYSTEM FOR AN ELECTRIC DRIVE SYSTEM**
LEISTUNGSÜBERWACHUNGSSYSTEM FÜR EIN ELEKTRISCHES ANTRIEBSSYSTEM
SYSTÈME DE SURVEILLANCE DE PERFORMANCES D'UN SYSTÈME D'ENTRAÎNEMENT ÉLECTRIQUE

(30) Priority: 19.07.2018 US 201816040080
(43) Date of publication of application: 22.01.2020
(73) Proprietor: Aurora Flight Sciences Corporation, Manassas, VA 20110 (US)
(72) Inventor: NEEDHAM, Thomas Richard, Chicago, IL 60606-1596 (US); BOSWORTH, William Robert, Chicago, IL 60606-1596 (US)
(74) Representative: Howson, Richard Giles Bentham

(56) References cited:
- WO-A1-2018/109677
- CN-A- 106 199 429
- CN-A- 107 479 529
- US-A1- 2007 278 986
- US-A1- 2017 072 812

## Description

### FIELD

The present disclosure relates to electric motors and electric drive systems and more particularly to a performance monitoring system for an electric drive system.

### BACKGROUND

Current brushless direct current (DC) motors are analyzed using an assumption of continuous alternating current (AC) power. This analysis method uses existing power meters that are too large to permanently install on vehicles or other systems for proper measurement and results in inaccurate monitoring that does not include load and efficiency.

CN106199429 in accordance with its abstract recites "The invention discloses a motor online monitoring device including a data measurement module, a data processing module, a data acquisition module, a host computer monitoring platform, and a drive circuit module connected in sequence and the power circuit module. The monitoring method of the device includes: using the data measurement module to obtain the motor parameters, after the data processing module processes the data collection module to collect the data at high speed, and at the same time transfer the collected data to the upper computer monitoring platform to realize the motor parameters process, display, save, replay and alarm shutdown to realize humancomputer interaction. The invention changes the traditional detection method, using online monitoring technology, can more accurately and real-time grasp the running state of the motor, and has great value for the research of motor speed control system control strategy and fault analysis. The motor online monitoring device and fault diagnosis must become the direction of future development".

### SUMMARY

In an aspect there is provided a performance monitoring system as defined in claim 1

In accordance with the aspect of claim 1, a performance monitoring system for an electric drive system includes a speed controller configured to operatively couple a power source to an electric motor. The electric drive system performance monitoring system also includes a plurality of sensors to measure performance metrics associated with the power source, speed controller and the electric motor. The electric drive system performance monitoring system further includes a health/performance monitoring system including a processor and a data storage device. The health/performance monitoring system is configured to determine an efficiency of operation and health of the electric drive system based on the measured performance metrics.

In accordance with another example, a performance monitoring system for an electric drive system includes an electric motor, a speed controller that controls the speed of the electric motor, and a power source that provides electrical power for driving the electric motor. The performance monitoring system also includes a sensor for measuring one or more performance metrics associated with the electric motor and another sensor for measuring one or more performance metrics associated with the speed controller. The performance monitoring system further includes a health/performance monitoring system. The health/performance monitoring system includes a processor and a data storage device. The health/performance monitoring system is configured to receive measurements of current and voltage supplied from the power source, measurements of current and voltage supplied from the speed controller to the electric motor, and measurements of the speed of the electric motor. The health/performance monitoring system is further configured to determine an efficiency of operation and health of the electric drive system using the current and voltage measurements and the speed measurements of the electric motor.

In accordance with an additional example, a performance monitoring system for a multi-motor aerial vehicle including a plurality of electric drive systems mounted to the multi-motor aerial vehicle. Each electric drive system includes an electric motor and a speed controller. A power source provides electrical power for driving each electric motor. Each speed controller operatively couples the power source to an associated electric motor. The performance monitoring system also includes a plurality of sensors for measuring performance metrics associated with the power source, each speed controller and each of the electric motors. The performance monitoring system further includes a health/performance monitoring system that includes a processor and a data storage device. The health/performance monitoring system is configured to receive measurements of current and voltage supplied from the power source, measurements of current and voltage supplied from each speed controller to the associated electric motor, and measurements of the speed of each electric motor. The health/performance monitoring system is further configured to determine an efficiency of operation and health of each electric drive system using the current and voltage measurements and the speed measurements of each electric motor. An output of each electric motor is controlled based on the efficiency of operation and health of each electric drive system.

In accordance with a further example, a method for monitoring an electric drive system includes receiving current and voltage measurements of electrical power supplied to a speed controller by a power source and receiving current and voltage measurements of electrical power driving the electric motor. The speed controller operatively couples the power source to the electric motor to provide electrical power to drive the electric motor. The method also includes measuring speed of the electric motor and determining an efficiency of operation and health of the electric drive system by a health/performance monitoring system using the current and voltage measurements and the speed measurements of the electric motor.

In accordance with an example and any of the previous examples, the plurality of sensors include a sensor for measuring current and voltage supplied from the power source and a sensor for measuring current and voltage supplied from the speed controller to the electric motor. The sensors additionally include a sensor for measuring speed of the electric motor.

In accordance with an example and any of the previous examples, the health/performance monitoring system is configured to receive measurements of the current and voltage supplied from the power source, measurements of the current and voltage supplied from the speed controller to the electric motor, and measurements of the speed of the electric motor. The health/performance monitoring system or the processor of the health/performance monitoring system is configured to determine the efficiency of operation and the health of the electric drive system using the current and voltage measurements and speed measurements.

In accordance with an example and any of the previous examples, the plurality of sensors further include a sensor for measuring temperature associated with the electric motor and a sensor for measuring vibrations associated with the electric motor.

In accordance with an example and any of the previous examples, the plurality of sensors additionally include other sensors separate from the electric motor for measuring vibration which are used to distinguish vibrations unique to the electric motor from other vibrations that may be experienced by a vehicle or other system. The plurality of sensors further include other sensors separate from the electric motor for measuring temperatures which are used to distinguish temperatures unique to the electric motor from other temperatures that may be experienced by the vehicle or system.

In accordance with an example and any of the previous examples, the health/performance monitoring system is configured to receive measurements of the current and voltage supplied from the power source, measurements of the current and voltage supplied from the speed controller to the electric motor, measurements of the speed of the electric motor, and measurements of the temperature and vibrations associated with the electric motor, wherein the health/performance monitoring system or processor is configured to determine the efficiency of operation and the health of the electric drive system using the current and voltage measurements, the speedmeasurements and the temperature and vibration measurements associated with the electric motor.

In accordance with an example and any of the previous examples, the processor is configured to perform a set of functions including logging power and efficiency data associated with the electric motor and/or electric drive system; logging temperature data associated with the electric motor; logging vibration data associated with the electric motor; and performing a predetermined action in response to any of the data exceeding a preset limit.

In accordance with an example and any of the previous examples, the predetermined action includes at least one of: generating an alert message; transmitting a message including a recommended course of action; and switching from using the electric motor or electric drive system to a redundant motor or system.

In accordance with an example and any of the previous examples, the performance monitoring system further includes an interface for presenting the alert message and/or the message including the recommended course of action.

In accordance with an example and any of the previous examples, wherein the health/performance monitoring system includes a micropower meter. The micropower meter includes an analog front end configured to receive the performance metrics measurements.

In accordance with an example and any of the previous examples, wherein the analog front end includes a plurality of programmable analog blocks that are programmable to receive different types of measurement signals. The analog front end is also configured to perform analog signal filtering and analog-to-digital converting.

In accordance with an example and any of the previous examples, wherein the speed controller provides three-phase electrical power to the electric motor via three-phase electrical conductors connected between the speed controller and the electric motor. The sensor for measuring the voltage and current supplied by the speed controller includes a separate voltage and current measurement sensor coupled to each phase of the three-phase electrical conductors.

In accordance with an example and any of the previous examples, the electric motor includes a brushless direct current (DC) electric motor.

In accordance with an example and any of the previous examples, the speed controller is configured to convert a source voltage from the power source to three-phase chopped DC square waves. Each wave includes a square wave frequency that is a predetermined number of orders of magnitude higher than a commutation frequency of the electric motor.

In accordance with an example and any of the previous examples, the speed controller is configured to pulse-width modulate each of the three-phase chopped DC square waves to supply approximately a sinusoidal phase signal on each phase of three-phase electrical power supplied to the electric motor.

In accordance with an example and any of the previous examples, the performance monitoring system is onboard a vehicle and the performance monitoring system further includes a vehicle controller in signal communication with the health/performance monitoring system. The vehicle controller is configured to perform a set of functions including providing throttle control signals to the speed controller; logging power and efficiency data associated with the electric motor and/or electric drive system; logging health data associated with the electric motor and/or electric drive system; and performing a predetermined action in response to any of the data exceeding a preset limit.

In accordance with an example and any of the previous examples, wherein the vehicle is an aerial vehicle or a spacecraft.

In accordance with an example and any of the previous examples, wherein the performance monitoring system is onboard an aerial vehicle. The aerial vehicle includes a plurality of electric drives systems. Each electric drive system includes an electric motor and a speed controller associated with each electric motor. The plurality of sensors include a sensor associated with each electric motor and a sensor associated with each speed controller to measure the performance metrics associated with each motor and each speed controller. An output of each electric motor is controlled based on the efficiency of operation and health of each electric drive system.

The features, functions, and advantages that have been discussed can be achieved independently in various examples or may be combined in yet other examples further details of which can be seen with reference to the following description and drawings.

### BRIEF DESCRIPTION OF THE DRAWINGS

FIG. 1 is a block schematic diagram of an example of an electric drive system including a performance monitoring system in accordance with an example of the present disclosure.
FIG. 2 is a block schematic diagram of an example of an electric drive system including a performance monitoring system in accordance with another example of the present disclosure.
FIG. 3 is a block schematic diagram of an example of a multi-motor vehicle or aerial vehicle including a performance monitoring system in accordance with a further example of the present disclosure.
FIGS. 4A and 4B are a flow chart of an example of a method for monitoring an electric drive system in accordance with an example of the present disclosure.
FIG. 5 is an illustration of an example of three-phase chopped DC square waveforms for driving a brushless DC motor in accordance with an example of the present disclosure.
FIG. 6 is an illustration of an example of pulse width modulation (PWM) of a DC square waveform to provide an approximation of a sinusoidal phase signal for driving a brushless DC motor in accordance with an example of the present disclosure.

### DETAILED DESCRIPTION

The following detailed description of examples refers to the accompanying drawings, which illustrate specific examples of the disclosure. Other examples having different structures and operations do not depart from the scope of the present disclosure. Like reference numerals may refer to the same element or component in the different drawings.

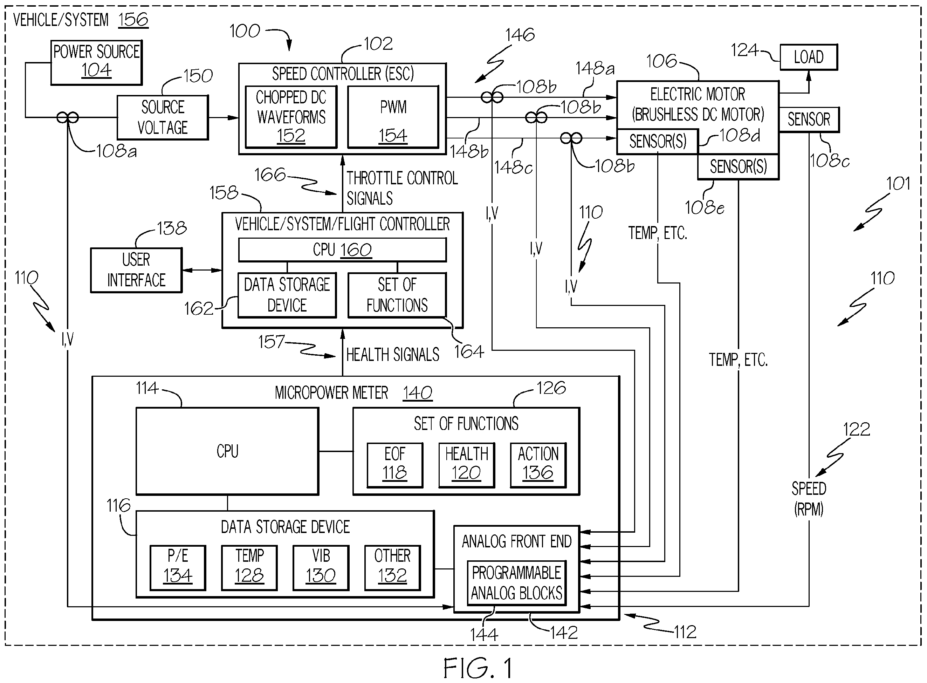

FIG. 1 is a block schematic diagram of an example of an electric drive system 100 including performance monitoring system 101 in accordance with an example of the present disclosure. The electric drive system 100 includes a speed controller 102 and an electric motor 106. The speed controller is configured to operatively couple a power source 104 to the electric motor 106. The speed controller 102 may be an electronic speed controller (ESC). The electric drive system 100 and/or performance monitoring system 101 also includes a plurality of sensors 108 to measure performance metrics 110 associated with the power source 104, the speed controller 102 and the electric motor 106. The electric drive system 100 and/or performance monitoring system 101 further includes a health/performance monitoring system 112 including a processor 114 or central processing unit (CPU) and a data storage device 116. The health/performance monitoring system 112 is configured to determine an efficiency of operation 118 and health 120 or mechanical condition of the electric drive system 100 based on the measured performance metrics 110.

In accordance with an example, the plurality of sensors 108 include a sensor 108a for measuring current and voltage (I,V) supplied from the power source 104 to the speed controller 102 and a sensor 108b or sensors 108b for measuring current and voltage (I,V) supplied from the speed controller 102 to the electric motor 106. The plurality of sensors 108 additionally include a sensor 108c for measuring speed of the electric motor 106. The speed measurements 122 may be in revolutions per minute (RPM). Sensing the speed of the electric motor 106 detects any stalls or drift where the speed controller 102 has not commanded a change. The electric motor 106 is mechanically coupled to or drives any type of load 124 or mechanical equipment.

In accordance with an example, the plurality of sensors 108 also include a sensor 108d for measuring temperature associated with the electric motor 106 and a sensor 108e for measuring vibrations associated with the electric motor 106. In accordance with different examples, the sensors 108d and 108e for measuring temperature and vibration associated with the electric motor 106 include sensors 108d and 108e positioned within the electric motor 106, on the electric motor 106 or both inside and outside the electric motor 106.

In accordance with an example, the plurality of sensors 108 additionally include other sensors 108e separate from the electric motor 106 for measuring vibration which are used to distinguish vibrations unique to the electric motor 106 from other vibrations that may be experienced by a vehicle 156 or system. The plurality of sensors 108 may further include other sensors 108d separate from the electric motor 106 for measuring temperatures which are used to distinguish temperatures unique to the electric motor 106 from other temperatures that may be experienced by the vehicle 156 or system.

The health/performance monitoring system 112 is configured to receive measurements of the current and voltage (I,V) supplied from the power source 104 to the speed controller 102, measurements of the current and voltage (I,V) supplied from the speed controller 102 to the electric motor 106, and speed measurements 122 of the electric motor 106. The health/performance monitoring system 112 or the processor 114 is configured to perform a set of functions 126. The set of functions include determining the efficiency of operation 118 and the health 120 of the electric drive system 100 using the current and voltage measurements (I,V) and speed measurements 122. In accordance with an example, the health/performance monitoring system 112 is also configured to receive temperature measurements 128, vibration measurements 130 associated with the electric motor 106 and any other measurements 132 or data useful in determining the efficiency of operation 118 and health 120 of the electric motor 106. The health/performance monitoring system 112 or processor 114 of the health/performance monitoring system 112 is configured to determine the efficiency of operation 118 and the health 120 of the electric drive system 100 using the current and voltage measurements (I,V), the speed measurements 122 and the temperature measurements 128 and vibration measurements 130 associated with the electric motor 106. The temperature measurements 128, vibration measurements 130 and any other measurements 132 or data may be stored on the data storage device 116.

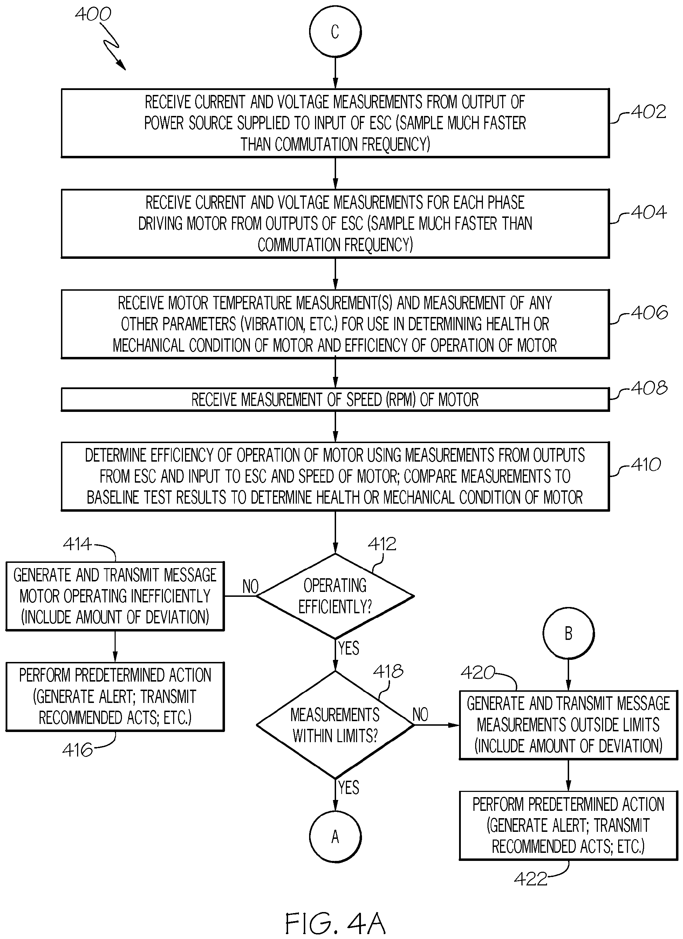

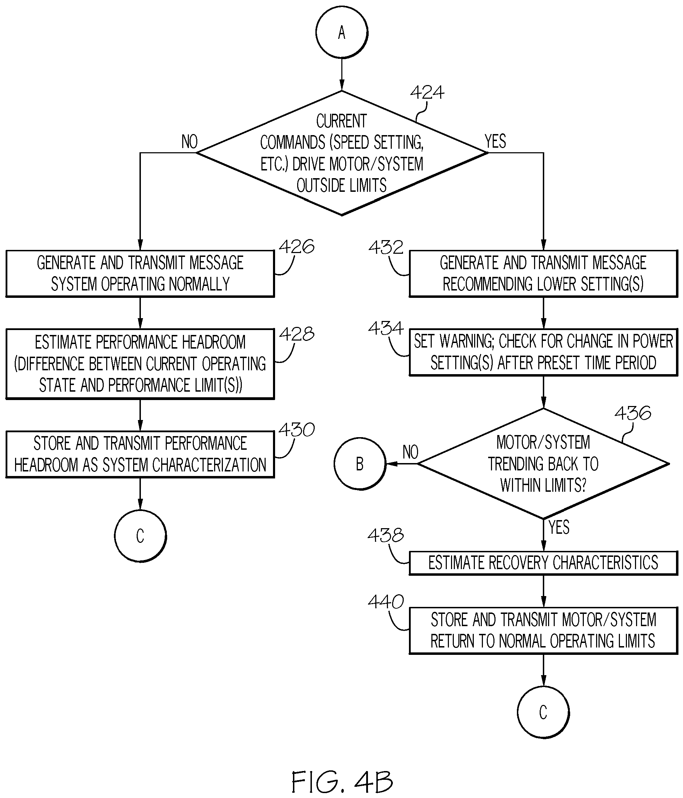

The processor 114 of the health/performance monitoring system 112 is configured to perform the set of functions 126 which include logging power and efficiency data 134 associated with the electric drive system 100 or electric motor 106; logging temperature measurements 128 or data associated with the electric motor 106; and logging vibration measurements 130 or data associated with the electric motor 106 and any other measurements 132 or data. The set of functions 126 further include performing a predetermined action 136 in response to any of the data exceeding a preset limit as described in more detail herein with reference to the exemplary method 400 in FIGS. 4A and 4B. In accordance with an example, the power and efficiency data 134, temperature measurements 128, vibration measurements 130 and other measurements 132 are stored on the data storage device 116 associated with the health/performance monitoring system 112. In the example of FIG. 1, the data storage device 116 is a component of the health/performance monitoring system 112.

The health/performance monitoring system 112 or processor 114 is configured to determine the efficiency of operation 118 and health 120 of the electric drive system 100 using the current and voltage measurements (I,V) and the speed measurements 122 of the electric motor 106. The efficiency of operation 118 of the electric drive system 100 or electric motor 106 may be defined as a ratio of an amount of mechanical energy or work produced by the electric motor 106 divided by the electrical energy or power supplied to the electric motor 106. The health 120 or mechanical condition of the electric drive system 100 or electric motor 106 may be determined by operating parameters, such as temperature, vibration or other parameters indicative of the health 120 or mechanical condition of the electric drive system 100 or electric motor 106 being within normal operating ranges or limits or baseline test data. Normal operating ranges or limits or baseline test data may be provided by a manufacture for a particular motor.

In accordance with an example and as described in more detail with respect to FIGS. 4A and 4B, the predetermined action 136 or actions include at least one of: generating an alert message; transmitting a message comprising a recommended course of action; and switching from using the electric drive system 100 or electric motor 106 to a redundant system or motor. A user interface 138 is provided for presenting the alert message and/or the message comprising the recommended course of action.

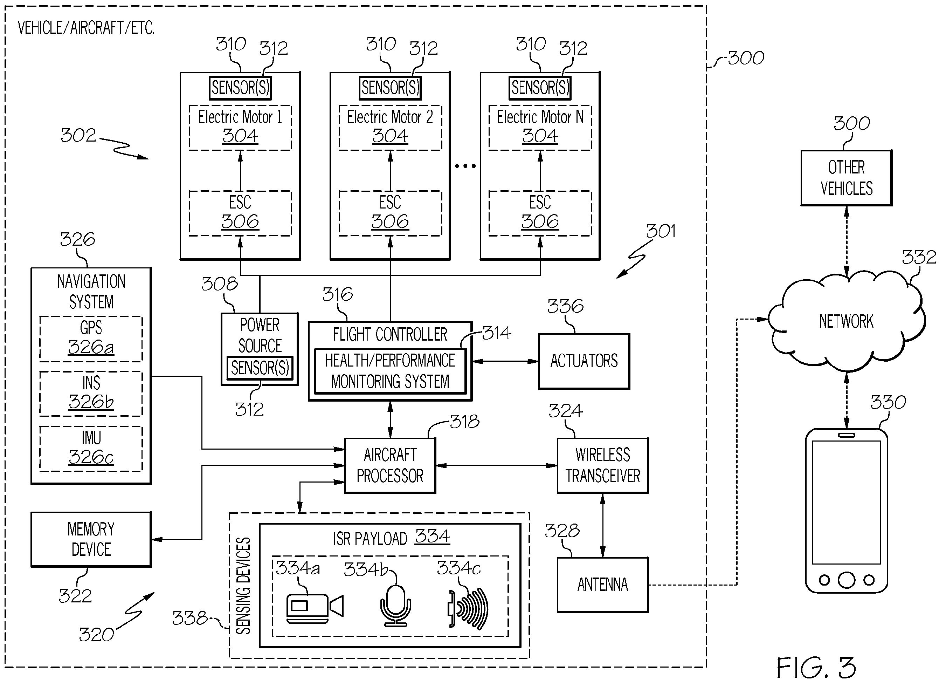

In accordance with an example, the health/performance monitoring system 112 includes a micropower meter 140. The micropower meter 140 may be a programmable system-on-chip or similar electronic device. The micropower meter 140 provides a miniaturized power meter scheme built into deployable systems that provide real-time or near real-time efficiency of operation and health monitoring of electric powertrains. The electric powertrain may be defined as the power source 104, speed controller 102, electric motor 106 to convert current to torque, and any gear arrangement or other mechanical equipment to couple the electric motor 106 to the load 124. The micropower meter 140 permits accurate measurement of current and voltage at the input to the speed controller 102 and each of the three-phase conductors 148a-148c powering the electric motor 106 in a compact package that is installed along with the speed controller 102. The micropower meter 140 includes an analog front end 142 configured to receive the performance metrics 110 or measurements. The analog front end 142 includes a plurality of programmable analog blocks 144 that are programmable to receive different types of measurement signals or data. The analog front end 142 also includes a filter (not shown in FIG. 3) to perform analog signal filtering and an analog-to-digital converter (not shown in FIG. 3) for analog-to-digital conversion. The micropower meter 140 is configured to convert analog measurements or signals from the sensors 108 to digital data, compare the digital data to baseline or normal operating data and report operating efficiency and health data or signals 157 to the system or vehicle controller 158 as described herein. In accordance with another example, the system or vehicle controller 158 is a flight controller of an aerial vehicle as describe herein.

In accordance with an example, the electric motor 106 includes a brushless direct current (DC) electric motor. The speed controller 102 provides three-phase electrical power 146 to the electric motor 106 via three-phase electrical conductors 148a-148c connected between the speed controller 102 and the electric motor 106. The sensor 108b for measuring the voltage and current supplied by the speed controller 102 includes a separate voltage and current measurement sensor 108b coupled to each phase of the three-phase electrical conductors 148a-148c. While the exemplary example in FIG. 1 has been described with respect to three-phase electrical power 146, the features of the examples described herein are configurable for use with any type electric drive system including electric drive systems with more than three-phases or less than three-phases.

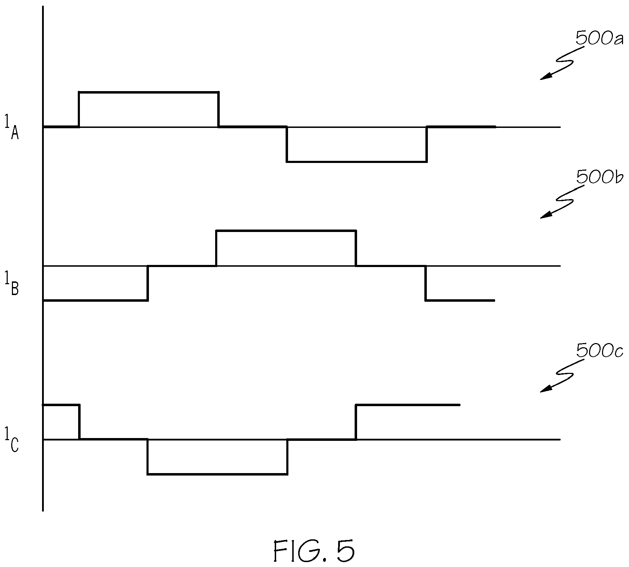

In accordance with an example, the speed controller 102 is configured to convert a source voltage 150 from the power source 104 to three-phase chopped DC square waveforms 152. Each waveform 152 includes a square wave frequency that is a predetermined number of orders of magnitude higher than a commutation frequency of the electric motor 106. Referring also to FIG. 5, FIG. 5 is an illustration of an example of three-phase chopped DC square waveforms 500a, 500b and 500c for driving a brushless DC motor in accordance with an example of the present disclosure. The three-phase chopped DC waveforms 500a, 500b and 500c may be used for the waveforms 152.

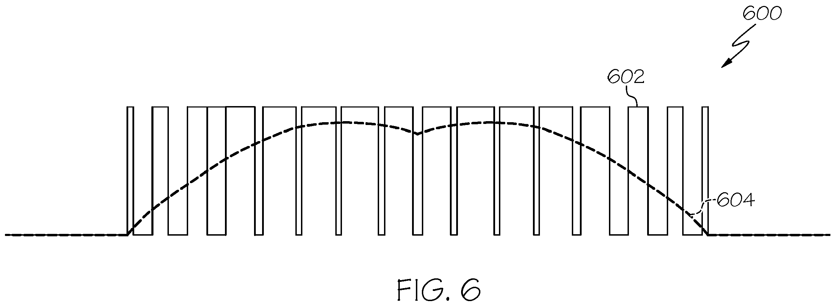

In accordance with a further example, the speed controller 102 is configured to pulse-width modulate 154 each of the three-phase chopped DC square waveforms 152 to supply approximately a sinusoidal phase signal on each phase of three-phase electrical power 146 supplied to the electric motor 106. Referring also to FIG. 6, FIG. 6 is an illustration of an example of pulse width modulation (PWM) 600 of a DC square waveform 602 to provide an approximation of a sinusoidal phase signal 604 for driving a brushless DC motor in accordance with an example of the present disclosure.

In accordance with an example, the electric drive system 100 is onboard a vehicle 156 and the electric drive system 100 and performance monitoring system 101 further include a vehicle controller 158 in signal communication with the health/performance monitoring system 112. In accordance with the example illustrated in FIG. 1, the vehicle controller 158 includes a processor 160 or central processing unit (CPU) and a data storage device 162. The vehicle controller 158 or processor 160 is configured to perform a set of functions 164 including providing throttle control signals 166 to the speed controller 102; logging power and efficiency data 134 associated with the electric drive system 100 and/or electric motor 106; logging health data 120 associated with the electric drive system 100 and/or electric motor 106; and performing a predetermined action 136 in response to any of the data exceeding a preset limit. Accordingly, the data storage device 162 may store measurements or data similar to the data storage device 116.

In accordance with an example, the vehicle 156 is an aerial vehicle or a spacecraft. A further example of a performance monitoring system, such as performance monitoring system 101, being implemented in an aerial vehicle including a plurality of electric drive systems will be described in more detail with reference to FIG. 3.

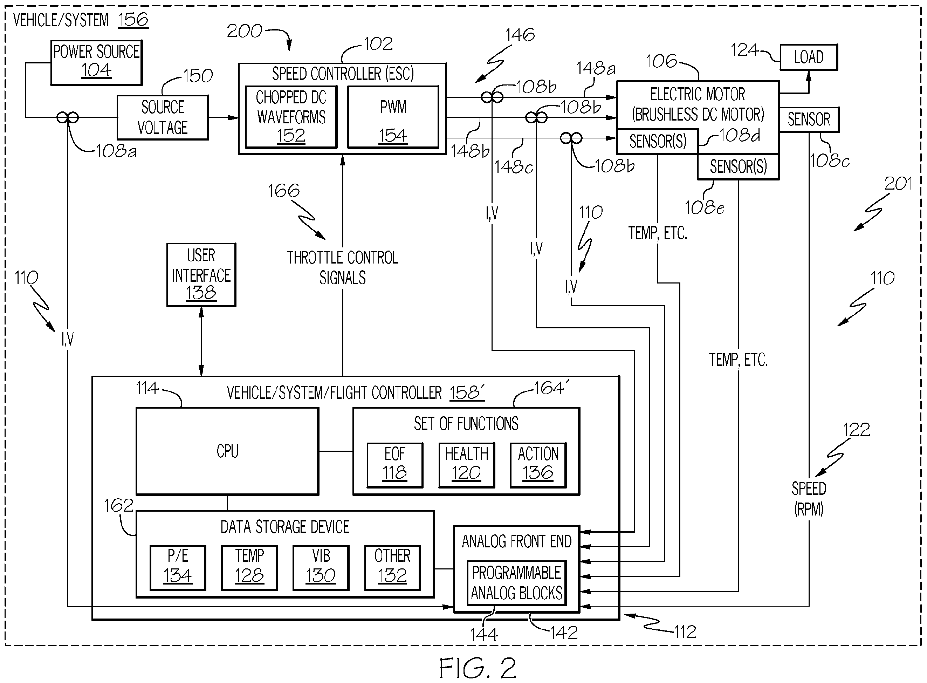

FIG. 2 is a block schematic diagram of an example of an electric drive system 200 including a performance monitoring system 201 in accordance with another example of the present disclosure. The electric drive system 200 is substantially the same as the electric drive system 100 in FIG. 1. The performance monitoring system 201 is similar to the performance monitoring system 201 in FIG. 1 except the health/performance monitoring system 112 is embodied in the vehicle controller 158'. Accordingly, the vehicle controller 158' is configured to perform a set of functions 164' that includes the set of functions 126 described with respect to the health/performance monitoring system 112 in FIG. 1 as well as the set of functions 164 of the vehicle controller 158 in FIG.1.

FIG. 3 is a block schematic diagram of an example of a multi-motor vehicle or aerial vehicle 300 including a performance monitoring system 301 in accordance with a further example of the present disclosure. The performance monitoring system 301 is substantially the same or similar to the performance monitoring system 101 in FIG. 1 or performance monitoring system 201 in FIG. 2. In one example, the aerial vehicle 300 is a multi-rotor aerial vehicle or drone. The aerial vehicle 300 includes a plurality of electric drive systems 302 mounted to the aerial vehicle 300. Each electric drive system 302 includes an electric motor 304 and a speed controller or electronic speed controller (ESC) 306. One or more power sources 308 provide electrical power for driving the electric motors 304. Each speed controller or ESC 306 operatively couples the power source 308 or at least one of the power sources 308 to an associated electric motor 304. In accordance with an example, each ESC 306 and associated electric motor 304 define a thrust generator 310 operatively connected to a propeller or rotor (not shown) to provide lift and/or thrust to the aerial vehicle 300. The performance monitoring system 301 additionally includes a plurality of sensors 312 for measuring performance metrics associated with the power source 308, each speed controller or ESC 306 and each of the electric motors 304. The sensors 312 are similar or the same as the sensors 108 described with reference to FIGS. 1 and 2 and are located at similar locations to that described with reference to FIGS. 1 and 2 or as illustrated in FIGS. 1 and 2.

The performance monitoring system 301 also includes a health/performance monitoring system 314. In accordance with the exemplary example in FIG. 3, the health/performance monitoring system 314 is a component of a flight controller 316. In other examples, the health/performance monitoring system 314 is a component of an aircraft processor 318 or the health/performance monitoring system 314 is a separate component that is communicatively coupled to either the flight controller 316, aircraft processor 318 or both. The health/performance monitoring system 314 is the same or similar to the health/performance monitoring system 112 described with reference to FIGS. 1 and 2 and is configured to perform the same or similar functions. According, the health/performance monitoring system 314 is configured to receive measurements of current and voltage supplied from the power source 308 or sources, measurements of current and voltage supplied from each ESC 306 to the associated electric motor 304, and measurements of the speed of each electric motor 304. The health/performance monitoring system 314 is further configured to determine an efficiency of operation and health of each electric drive system 302 or electric motor 304 using the current and voltage measurements and the speed measurements of each electric motor 304. An output of each electric motor 304 is controlled via the associated speed controller or ESC 306 based on the efficiency of operation and health of each electric drive system 302 or electric motor 304 similar to that previously described and as described in the exemplary method 400 in FIGS. 4A and 4B.

FIG. 3 also illustrates a block diagram of an exemplary flight control system 320 for the aerial vehicle 300. The flight control system 320 may be configured to control the various components and functions of the aerial vehicle 300. As illustrated, the flight control system 320 includes one or more aircraft processors 318 communicatively coupled with at least one memory device 322, the flight controller 316, a wireless transceiver 324, and a navigation system 326. The aircraft processor 318 may be configured to perform one or more operations based at least in part on instructions (e.g., software) and one or more databases stored to the memory device 322 (e.g., hard drive, flash memory, or the like). The aerial vehicle 300 may further include other desired services, such as the wireless transceiver 324 coupled with an antenna 328 to communicate data between the flight control system 320 and a remote device 330 (e.g., a portable electronic devices, such as smartphones, tablets, laptop computers) or other controller (e.g., at a base station). The flight control system 320 may also communicate with another aerial vehicle 300 via the wireless transceiver 324, thereby facilitating collaborative operations, for example.

In certain aspects, the flight control system 320 may communicate data (processed data, unprocessed data, etc.) with the remote device 330 and/or another aerial vehicle 300 over a network 332. In certain aspects, the wireless transceiver 324 may be configured to communicate using one or more wireless standards such as Bluetooth (e.g., short-wavelength, Ultra-High Frequency (UHF) radio waves in the Industrial, Scientific, and Medical (ISM) band from 2.4 to 2.485 GHz), near-field communication (NFC), Wi-Fi (e.g., Institute of Electrical and Electronics Engineers' (IEEE) 802.11 standards), etc. The remote device 330 may facilitate monitoring and/or control of the flight control system 320 and its payload(s), including an intelligence, surveillance, and reconnaissance (ISR) payload 334.

The remote device 330 provides a control and communication interface for a user. The remote device 330 may be configurable to operate as a manager that enables the user to monitor, direct, and control systems onboard the aerial vehicle 300. The remote device 330 can be used to enable a user to input tasks, constraints, revise task assignment lists, update software/firmware, etc. The remote device 330 may include a touch screen graphical user interface ("GUI") and/or speech-recognition systems. The remote device 330 may employ, for example, a tablet computer, a laptop computer, a smart phone, or combination thereof. The remote device 330 serves as a primary channel of communication between the pilot and systems onboard the aerial vehicle 300, enabling the user to command tasks to and receive feedback or instructions. The remote device 330 may give visual and auditory alerts to direct the pilot's attention to a particular alert.

The aircraft processor 318 may be operatively coupled to the flight controller 316 to control operation of various actuators 336 (e.g., those to control movement and locking of any flight surfaces, such as the moveable flight control surfaces, electric motor 304 (e.g., via the electronic speed controller (ESC) 306) in response to commands from an operator, autopilot, a navigation system 326, or other high-level system via the wireless transceiver 324. In certain aspects, the aircraft processor 318 and the flight controller 316 may be integrated into a single component or circuit. In operation, the flight controller 316 may dynamically (i.e., in real-time or near real-time) and independently adjust thrust during the various stages of flight via the ESC 306 to control roll, pitch, or yaw of the aerial vehicle 300. When rotors with rotor blades (e.g., propellers) are used, the flight controller 316 may vary the revolutions per minute (RPM) of the rotor and/or, where desired, vary the pitch of the rotor blades. For example, the electric motors 304 may be controlled by adjusting power supplied to each electric motor 304 from the power source 308 (e.g., a battery pack or a battery bank) via the ESC 306.

The aircraft processor 318 may be operatively coupled to the navigation system 326, which may include a global positioning system (GPS) 326a that is communicatively coupled with an inertial navigation system (INS) 326b and/or an inertial measurement unit (IMU) 326c, which can include one or more gyros and accelerometers. The GPS 326a gives an absolute drift-free position value that can be used to reset the INS solution or can be blended with it by use of a mathematical algorithm, such as a Kalman Filter. The navigation system 326 may communicate, inter alia, inertial stabilization data to the aircraft processor 318.

To collect data and/or monitor an area, the flight control system 320 may be equipped with additional sensing devices 338, such as the ISR payload 334 including, for example, one or more cameras 334a (e.g., an optical instrument for recording or capturing images and/or video, including light detection and ranging (LiDAR) devices), audio devices 334b (e.g., microphones, echolocation sensors, etc.), and other sensor devices 334c to facilitated ISR functionality and provide ISR data (e.g., photographs, video, audio, sensor measurements, etc.). The ISR payload 334 is operatively coupled to the aircraft processor 318 to facilitate communication of the ISR data (sensor data) between the ISR payload 334 and the aircraft processor 318. The ISR data may be used to navigate the aerial vehicle 300 and/or otherwise control the flight control system 320. In certain aspects, the ISR payload 334 may be rotatably and pivotally coupled to, for example, the underside surface of an airframe of the aerial vehicle 300 (or another structural component, such as the rotor booms or the wings of the aerial vehicle 300) via a gimbal system to enable the ISR payload 334 to be more easily oriented downward to monitor objects below and/or on the ground. The data may be dynamically or periodically communicated from the flight control system 320 to the remote device 330 over the network 332 via the wireless transceiver 324, or stored to the memory device 322 for later access or processing.

FIGS. 4A and 4B are a flow chart of an example of a method 400 for monitoring an electric motor in accordance with an example of the present disclosure. In accordance with an example, the method 400 is embodied in and performed by the performance monitoring system 101 in FIG. 1 or 201 in FIG. 2 and the performance monitoring system 301 in FIG. 3.

In block 402, current and voltage measurements of electrical power supplied to a speed controller or ESC by a power source are received. In block 404, current and voltage measurements from each phase driving an electric motor are received. In accordance with an example, the speed controller provides three-phase electrical power to drive the electric motor. The current and voltage measurements are performed or sampled at a much faster frequency than a commutation frequency of the motor. The current and voltage measurements are performed or sampled at the much faster frequency than the commutation frequency to capture any spikes and the pulses to the motor accurately.

In block 406, temperature measurements and measurements of any other parameters or performance metrics (e.g. vibration, etc.) are received for use in determining health or mechanical condition of the motor and efficiency of operation of the motor.

In block 408, speed of the motor is measured and received. Sensing the speed of the motor detects any stalls or drift where the speed controller has not commanded a change. In block 410, an efficiency of operation and health of the motor is determined by a health/performance monitoring system using the current and voltage measurements, the speed measurements and any other measured parameters or metrics associated with operation of the motor. In accordance with an example, measurements are compared to baseline test results or normal operating parameters to determine the health or mechanical condition of the motor. Efficiency of operation is determined by comparing output mechanical energy or work to input electrical energy or by determining a ratio of the output mechanical energy or work divided by the input electrical energy or power. Output mechanical energy or work may be determined from the speed of the electric motor based on the characteristics of the load driven by the electric motor.

In block 412, a determination is made if the motor is operating efficiently. The motor is operating efficiently if the ratio of the output mechanical energy or work divided by the input electrical energy or power exceeds a preset threshold for the particular motor. The preset threshold may be determined and provided for the particular motor by the motor manufacturer. If the motor is not operating efficiently, the method 400 advances to block 414. In block 414, an alert or message is generated and transmitted to a user interface or other device that the motor is operating inefficiently. An amount of deviation from the preset threshold may be included in the message.

In block 416, a predetermined action or actions are performed in response to the motor operating inefficiently. Examples of the predetermined action or actions include but are not necessarily limited to generating an alert or message, transmitting a recommended course of action, or switching to a redundant motor or system. The method or system may automatically switch to the redundant motor or system, or recommend a pilot or operator switch to the redundant motor or system.

If the motor is operating efficiently in block 412, the method 400 advances to block 418. In block 418, a determination is made if the measurements in blocks 402-408 are within normal operating limits for the motor or baseline limits. If any of the measurements are not within normal operating limits or the baseline measurements, the method 400 advances to block 420. In block 420, a message is generated and transmitted to the user interface or other device that the measurements or particular measurements are outside of limits or the baseline and/or the motor is not operating within normal operating limits or parameters. For example, if the operating temperature of the motor is over a normal operating range or limit, or vibration measurements exceed normal operating parameters or baseline measurements, the message is generated and transmitted to the user interface. An amount of deviation from the normal operating limits or baseline may also be included with the message.

In block 422, a predetermined action or actions are performed in response to any of the measurements being outside normal operating limits or baseline measurements. Examples of the predetermined action or actions include but are not necessarily limited to generating an alert or message, transmitting a recommended course of action, or switching to a redundant motor or system.

If the measurements are within normal operating limits in block 418, the method 400 advances to block 424. In block 424, a determination is made whether the current command settings (speed or throttle settings, etc.) will drive the motor or system outside or beyond the normal operating limits. If the current command settings will not drive the motor or system beyond the normal operating limits, the method 400 advances to block 426. In block 426, a message is generated and transmitted to the user interface or other device that the system is operating normally or within limits.

In block 428, a performance headroom is estimated. The performance headroom may be defined as a difference between a current operating state and a performance limit or limits. In block 430, the performance headroom is stored and transmitted to the user interface as a system characterization. From block 430, the method 400 may return to block 402 and the method 400 may proceed as previously described to continue monitoring the motor.

Returning to block 424, if the current commands will drive the motor or system beyond or outside normal operating limits, the method 400 advances to block 432. In block 432, a message is generated and transmitted to the user interface recommending a lower operating setting or settings. In block 434, a warning is set and message transmitted to the user interface or other device. The method 400 or system will check for changes in a power setting or power settings after a preset time period in response to the warning being set.

In block 436, a determination is made whether the motor and/or system is trending back to within normal operating limits based on changes in the power setting or settings. If the motor and/or system is not trending back to within normal operating limits, the method 400 advances to block 420 and the method 400 proceeds similar that previously described with respect to blocks 420 and 422.

If the motor and/or system is trending back to within normal operating limits in block 436, the method 400 advances to block 438. In block 438, recovery characteristics for the motor and/or system returning to within limits are estimated. Examples of recovery characteristics include but are not necessarily limited to rates of temperature change for heat transfer coefficients, speed deviation recovery (characteristics of how the speed smooths out or normalizes after a deviation or what the derivative of speed samples does), power-in versus temperature for winding resistance changes, speed controller temperatures versus power resistance changes (e.g. efficiency in going back to normal operating temperatures after overheating and cooling back down or did speed controller and/or motor suffer damage and/or permanent loss of efficiency by operating under higher loads?). In block 440, the estimated recovery characteristic are stored. A message is generated and transmitted to the user interface or other device in response to the motor and/or system returning to normal operating limits. The method 400 may then return to block 402 and the method 400 may proceed as previously described to continue monitoring the motor.

The flowchart and block diagrams in the Figures illustrate the architecture, functionality, and operation of possible implementations of systems, methods, and computer program products according to various examples of the present disclosure. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

The terminology used herein is for the purpose of describing particular examples only and is not intended to be limiting of examples of the disclosure. As used herein, the singular forms "a", "an" and "the" are intended to include the plural forms as well, unless the context clearly indicates otherwise. It will be further understood that the terms "include," "includes," "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the present examples has been presented for purposes of illustration and description, but is not intended to be exhaustive or limited to examples in the form disclosed. Many modifications and variations will be apparent to those of ordinary skill in the art without departing from the scope of the appended claims.

## Claims

1. A performance monitoring system (101) for an electric drive system (100), comprising:
a speed controller (102) configured to operatively couple a power source (104) to an electric motor (106);
a plurality of sensors (108) to measure performance metrics (110) associated with the power source (104), the speed controller (102) and the electric motor (106); and
a health/performance monitoring system (112) comprising a processor (114) and a data storage device (116), wherein the health/performance monitoring system (112) is configured to determine an efficiency of operation (118) and health (120) of the electric drive system (100) based on the measured performance metrics (110);
wherein the plurality of sensors (108) comprise:
a sensor (108a) for measuring current and voltage supplied from the power source (104);
a sensor (108b) for measuring current and voltage supplied from the speed controller (102) to the electric motor (106); and
a sensor (108c) for measuring a speed of the electric motor (106);
a sensor (108d) for measuring temperature (128) associated with the electric motor (106); and
a sensor (108e) for measuring vibrations (130) associated with the electric motor (106),
wherein the health/performance monitoring system (112) is configured to receive measurements of the current and voltage (I,V) supplied from the power source (104), measurements of the current and voltage (I,V) supplied from the speed controller (102) to the electric motor (106), and measurements of the speed (122) of the electric motor (106), wherein the health/performance monitoring system (112) or the processor (114) is configured to determine the efficiency of operation (118) and the health (120) of the electric motor (106) using the current and voltage measurements (I,V) and speed measurements (122); and further wherein
the processor (114) is configured to perform a set of functions (126, 164, 164') comprising:
logging power and efficiency data (134) associated with the electric motor (106) and/or electric drive system (100);
logging temperature data (128) associated with the electric motor (106);
logging vibration data (130) associated with the electric motor (106); and
performing a predetermined action (136, 416) in response to any of the data (128, 130, 134) exceeding a preset limit.

2. The performance monitoring system (101) of claim 1, wherein the predetermined action (136, 416) comprises at least one of:
generating an alert message (416);
transmitting a message comprising a recommended course of action (416); and
switching from using the electric motor (106) or electric drive system (100) to a redundant motor or system.

3. The performance monitoring system (101) of claim 2, further comprising an interface for presenting the alert message and/or the message comprising the recommended course of action.

4. The performance monitoring system (101) of any of claims 1-3, wherein the health/performance monitoring system (112) comprises a micropower meter (140), the micropower meter (140) comprising an analog front end (142) configured to receive the performance metrics (110) measurements.

5. The performance monitoring system (101) of any of claims 1-4, wherein the analog front end (142) comprises a plurality of programmable analog blocks (144) blocks that are programmable to receive different types of measurement signals.

6. The performance monitoring system (101) of any of claims 1-5, wherein the speed controller (102) provides three-phase electrical power (146) to the electric motor (106) via three-phase electrical conductors (148a-148c) connected between the speed controller (102) and the electric motor (106), and wherein the sensor (108) for measuring the voltage and current (I,V) supplied by the speed controller (102) comprises a separate voltage and current measurement sensor (108b) coupled to each phase of the three-phase electrical conductors (148a-148c).

7. The performance monitoring system (101) of any of claims 1-6, wherein the electric motor (106) comprises a brushless direct current (DC) electric motor.

8. The performance monitoring system (101) of any of claims 1-7, wherein the speed controller (102) is configured to convert a source voltage (150) from the power source (104) to three-phase chopped DC square waves (500a-500c), each wave comprising a square wave frequency that is a predetermined number of orders of magnitude higher than a commutation frequency of the electric motor (106).

9. The performance monitoring system (101) of claim 8, wherein the speed controller (102) is configured to pulse-width modulate (154) each of the three-phase chopped DC square waves (500a-500c) to supply approximately a sinusoidal phase signal (604) on each phase of three-phase electrical power (146) supplied to the electric motor (106).

10. The performance monitoring system (101) of any of claims 1-9, wherein the electric motor (106) performance monitoring system (101) is onboard a vehicle (156) and the performance monitoring system (101) further comprises a vehicle controller (158) in signal communication with the health/performance monitoring system (112), the vehicle controller (158) being configured to perform a set of functions (164, 164') comprising:
providing throttle control signals (166) to the speed controller (102);
logging power and efficiency data (134) associated with the electric motor (106);
logging health data (120) associated with the electric motor (106); and
performing a predetermined action (136) in response to any of the data (120, 134) exceeding a preset limit.

11. The performance monitoring system (101) of any of claims 1-10, wherein the vehicle is an aerial vehicle or a spacecraft.

12. The performance monitoring system (101) of any of claims 1-11, wherein the performance monitoring system (101) is onboard an aerial vehicle (300), the aerial vehicle (300) comprising a plurality of electric drive systems (302), each electrical drive system comprising:
an electric motor (304); and
a speed controller (306) associated with each electric motor (304), wherein the plurality of sensors (312) comprise a sensor (312) associated with each electric motor (304) and a sensor (312) associated with each speed controller (306) to measure the performance metrics (110) associated with each electric motor (304) and each speed controller (306) and wherein an output of each electric motor (304) is controlled based on the efficiency of operation (118) and health (120) of each electric drive system (302).

## Patentansprüche

1. Leistungsüberwachungssystem (101) für ein elektrisches Antriebssystem (100), umfassend:
eine Geschwindigkeitssteuerung (102), die dazu konfiguriert ist, eine Energiequelle (104) operativ mit einem Elektromotor (106) zu koppeln;
eine Mehrzahl von Sensoren (108), um Leistungsmetriken (110) zu messen, die der Energiequelle (104), der Geschwindigkeitssteuerung (102) und dem Elektromotor (106) zugeordnet sind; und
ein Zustands-/Leistungsüberwachungssystem (112), das einen Prozessor (114) und eine Datenspeichervorrichtung (116) umfasst, wobei das Zustands-/Leistungsüberwachungssystem (112) dazu konfiguriert ist, eine Betriebseffizienz (118) und den Zustand (120) des elektrischen Antriebssystems (100) basierend auf den gemessenen Leistungsmetriken (110) zu bestimmen;
wobei die Mehrzahl der Sensoren (108) umfasst:
einen Sensor (108a) zum Messen von Strom und Spannung, die von der Energiequelle (104) zugeführt werden;
einen Sensor (108b) zum Messen von Strom und Spannung, die von der Geschwindigkeitssteuerung (102) dem Elektromotor (106) zugeführt werden; und
einen Sensor (108c) zum Messen einer Geschwindigkeit des Elektromotors (106);
einen Sensor (108d) zum Messen der Temperatur (128), die dem Elektromotor (106) zugeordnet ist; und
einen Sensor (108e) zum Messen von Schwingungen (130), die dem Elektromotors (106) zugeordnet sind,
wobei das Zustands-/Leistungsüberwachungssystem (112) dazu konfiguriert ist, Messungen des Stroms und der Spannung (I, V), die von der Energiequelle (104) zugeführt werden, Messungen des Stroms und der Spannung (I, V), die von der Geschwindigkeitssteuerung (102) dem Elektromotor (106) zugeführt werden, zu empfangen, und Messungen der Geschwindigkeit (122) des Elektromotors (106), wobei das Zustands-/Leistungsüberwachungssystem (112) oder der Prozessor (114) dazu konfiguriert ist, die Effizienz des Betriebs (118) und den Zustand (120) des Elektromotors (106) unter Verwendung der Strom- und Spannungsmessungen (I, V) und der Geschwindigkeitsmessungen (122) zu bestimmen; und wobei ferner
der Prozessor (114) dazu konfiguriert ist, einen Satz von Funktionen (126, 164, 164') durchzuführen, umfassend:
Aufzeichnen von Energie- und Effizienzdaten (134), die dem Elektromotor (106) und/oder dem elektrischen Antriebssystem (100) zugeordnet sind;
Aufzeichnen von Temperaturdaten (128), die dem Elektromotor (106) zugeordnet sind;
Aufzeichnen von Schwingungsdaten (130), die dem Elektromotor (106) zugeordnet sind; und
Durchführung einer vorbestimmten Handlung (136, 416) als Reaktion darauf, dass irgendwelche der Daten (128, 130, 134) einen voreingestellten Grenzwert überschreiten.

2. Leistungsüberwachungssystem (101) nach Anspruch 1, wobei die vorbestimmte Handlung (136, 416) umfasst:
Erzeugen einer Warnnachricht (416); und/oder Übertragen einer Nachricht, die einen empfohlenen Handlungsablauf umfasst (416); und/oder
Umschalten vom Verwenden des Elektromotors (106) oder des elektrischen Antriebssystems (100) auf einen redundanten Motor oder ein redundantes System.

3. Leistungsüberwachungssystem (101) nach Anspruch 2, ferner umfassend eine Schnittstelle zum Darstellen der Warnnachricht und/oder der Nachricht, die den empfohlenen Handlungsablauf umfasst.

4. Leistungsüberwachungssystem (101) nach einem der Ansprüche 1 bis 3, wobei das Zustands-/Leistungsüberwachungssystem (112) ein Mikroenergiemessgerät (140) umfasst, wobei das Mikroenergiemessgerät (140) ein analoges Frontend (142) umfasst, das dazu konfiguriert ist, die Messungen der Leistungsmetrik (110) zu empfangen.

5. Leistungsüberwachungssystem (101) nach einem der Ansprüche 1 bis 4, wobei das analoge Frontend (142) eine Mehrzahl von programmierbaren analogen Blöcken (144) umfasst, die programmiert werden können, um verschiedene Arten von Messsignalen zu empfangen.

6. Leistungsüberwachungssystem (101) nach einem der Ansprüche 1 bis 5, wobei die Geschwindigkeitssteuerung (102) dem Elektromotor (106) über dreiphasige elektrische Leiter (148a-148c), die zwischen die Geschwindigkeitssteuerung (102) und den Elektromotor (106) geschaltet sind, dreiphasige elektrische Energie (146) bereitstellt, und wobei der Sensor (108) zum Messen der von der Geschwindigkeitssteuerung (102) zugeführten Spannung und des Stroms (I, V) einen separaten Spannungsund Strommesssensor (108b) umfasst, der mit jeder Phase der dreiphasigen elektrischen Leiter (148a-148c) gekoppelt ist.

7. Leistungsüberwachungssystem (101) nach einem der Ansprüche 1 bis 6, wobei der Elektromotor (106) einen bürstenlosen Gleichstrom-Elektromotor (DC-Elektromotor) umfasst.

8. Leistungsüberwachungssystem (101) nach einem der Ansprüche 1 bis 7, wobei die Geschwindigkeitssteuerung (102) dazu konfiguriert ist, eine Quellenspannung (150) von der Energiequelle (104) in dreiphasige, zerhackte Gleichstrom-Rechteckwellen (500a bis 500c) umzuwandeln, wobei jede Welle eine Rechteckwellenfrequenz aufweist, die eine vorbestimmte Anzahl von Größenordnungen höher ist als eine Kommutierungsfrequenz des Elektromotors (106) .

9. Leistungsüberwachungssystem (101) nach Anspruch 8, wobei die Geschwindigkeitssteuerung (102) dazu konfiguriert ist, jede der dreiphasigen zerhackten Gleichstrom-Rechteckwellen (500a-500c) pulsbreitenmäßig zu modulieren (154), um ungefähr ein sinusförmiges Phasensignal (604) auf jeder Phase der dreiphasigen elektrischen Energie (146) zuzuführen, die dem Elektromotor (106) zugeführt wird.

10. Leistungsüberwachungssystem (101) nach einem der Ansprüche 1 bis 9, wobei sich das Leistungsüberwachungssystem (101) des Elektromotors (106) an Bord eines Fahrzeugs (156) befindet und das Leistungsüberwachungssystem (101) ferner eine Fahrzeugsteuerung (158) in Signalkommunikation mit dem Zustands-/Leistungsüberwachungssystem (112) umfasst, wobei die Fahrzeugsteuerung (158) dazu konfiguriert ist, einen Satz von Funktionen (164, 164') durchzuführen, umfassend:
Bereitstellen von Drosselsteuersignalen (166) an die Geschwindigkeitssteuerung (102);
Aufzeichnen von Energie- und Effizienzdaten (134), die dem Elektromotor (106) zugeordnet sind;
Aufzeichnen von Zustandsdaten (120), die dem Elektromotor (106) zugeordnet sind; und
Durchführen einer vorbestimmten Handlung (136) als Reaktion darauf, dass irgendwelche der Daten (120, 134) einen voreingestellten Grenzwert überschreiten.

11. Leistungsüberwachungssystem (101) nach einem der Ansprüche 1 bis 10, wobei das Fahrzeug ein Luftfahrzeug oder ein Raumfahrzeug ist.

12. Leistungsüberwachungssystem (101) nach einem der Ansprüche 1 bis 11, wobei sich das Leistungsüberwachungssystem (101) an Bord eines Luftfahrzeugs (300) befindet, wobei das Luftfahrzeug (300) eine Mehrzahl von elektrischen Antriebssystemen (302) umfasst, wobei jedes elektrische Antriebssystem umfasst:
einen Elektromotor (304); und
eine Geschwindigkeitssteuerung (306), die jedem Elektromotor (304) zugeordnet ist, wobei die mehreren Sensoren (312) einen Sensor (312), der jedem Elektromotor (304) zugeordnet ist, und einen Sensor (312), der jeder Geschwindigkeitssteuerung (306) zugeordnet ist, umfassen, um die jedem Elektromotor (304) und jeder Geschwindigkeitssteuerung (306) zugeordneten Leistungsmetriken (110) zu messen, und wobei eine Ausgabe jedes Elektromotors (304) basierend auf der Effizienz des Betriebs (118) und des Zustands (120) jedes elektrischen Antriebssystems (302) gesteuert wird.

## Revendications

1. Système de surveillance des performances (101) pour un système d'entraînement électrique (100), comprenant :
un régulateur de vitesse (102) configuré pour coupler fonctionnellement une source d'alimentation (104) à un moteur électrique (106) ;
une pluralité de capteurs (108) pour mesurer des métriques de performances (110) associées à la source d'alimentation (104), au régulateur de vitesse (102) et au moteur électrique (106) ; et
un système de surveillance de l'état de santé/des performances (112) comprenant un processeur (114) et un dispositif de stockage de données (116), le système de surveillance de l'état de santé/des performances (112) étant configuré pour déterminer une efficacité de fonctionnement (118) et un état de santé (120) du système d'entraînement électrique (100) sur la base des métriques de performances (110) mesurées ;
la pluralité de capteurs (108) comprenant :
un capteur (108a) pour mesurer un courant et une tension fournis par la source d'alimentation (104) ;
un capteur (108b) pour mesurer un courant et une tension fournis par le régulateur de vitesse (102) au moteur électrique (106) ; et
un capteur (108c) pour mesurer une vitesse du moteur électrique (106) ;
un capteur (108d) pour mesurer une température (128) associée au moteur électrique (106) ; et
un capteur (108e) pour mesurer des vibrations (130) associées au moteur électrique (106),
le système de surveillance de l'état de santé/des performances (112) étant configuré pour recevoir des mesures du courant et de la tension (I,V) fournis par la source d'alimentation (104), des mesures du courant et de la tension (I,V) fournis par le régulateur de vitesse (102) au moteur électrique (106), et des mesures de la vitesse (122) du moteur électrique (106), le système de surveillance de l'état de santé/des performances (112) ou le processeur (114) étant configuré pour déterminer l'efficacité de fonctionnement (118) et l'état de santé (120) du moteur électrique (106) au moyen des mesures du courant et de la tension (I,V) et de mesures de la vitesse (122) ; et en outre
le processeur (114) étant configuré pour exécuter un ensemble de fonctions (126, 164, 164') comprenant :
l'enregistrement de données de puissance et d'efficacité (134) associées au moteur électrique (106) et/ou au système d'entraînement électrique (100) ;
l'enregistrement de données de température (128) associées au moteur électrique (106) ;
l'enregistrement de données de vibrations (130) associées au moteur électrique (106) ; et
l'exécution d'une action prédéterminée (136, 416) dans le cas où des données quelconques parmi les données (128, 130, 134) dépassent une limite prédéfinie.

2. Système de surveillance des performances (101) selon la revendication 1, l'action prédéterminée (136, 416) comprenant :
la génération d'un message d'alerte (416) ; et/ou la transmission d'un message comprenant un plan d'action recommandé (416) ; et/ou
le passage de l'utilisation du moteur électrique (106) ou du système d'entraînement électrique (100) à l'utilisation d'un moteur ou système redondant.

3. Système de surveillance des performances (101) selon la revendication 2, comprenant en outre une interface de présentation du message d'alerte et/ou du message comprenant le plan d'action recommandé.

4. Système de surveillance des performances (101) selon l'une quelconque des revendications 1 à 3, le système de surveillance de l'état de santé/des performances (112) comprenant un microwattmètre (140), le microwattmètre (140) comprenant un frontal analogique (142) configuré pour recevoir les mesures des métriques de performances (110) .

5. Système de surveillance des performances (101) selon l'une quelconque des revendications 1 à 4, le frontal analogique (142) comprenant une pluralité de blocs analogiques programmables (144) qui sont programmables pour recevoir différents types de signaux de mesure.

6. Système de surveillance des performances (101) selon l'une quelconque des revendications 1 à 5, le régulateur de vitesse (102) fournissant une puissance électrique triphasée (146) au moteur électrique (106) via des conducteurs électriques triphasés (148a-148c) connectés entre le régulateur de vitesse (102) et le moteur électrique (106), et le capteur (108) pour mesurer la tension et le courant (I,V) fournis par le régulateur de vitesse (102) comprenant un capteur de mesure de tension et de courant (108b) distinct couplé à chaque phase des conducteurs électriques triphasés (148a-148c).

7. Système de surveillance des performances (101) selon l'une quelconque des revendications 1 à 6, le moteur électrique (106) comprenant un moteur électrique à courant continu (C.C.) sans balai.

8. Système de surveillance des performances (101) selon l'une quelconque des revendications 1 à 7, le régulateur de vitesse (102) étant configuré pour convertir une tension de source (150) issue de la source d'alimentation (104) en ondes carrées C.C. hachées triphasées (500a-500c), chaque onde comprenant une fréquence d'onde carrée qui est supérieure d'un nombre prédéterminé d'ordres de grandeur à une fréquence de commutation du moteur électrique (106).

9. Système de surveillance des performances (101) selon la revendication 8, le régulateur de vitesse (102) étant configuré pour moduler la largeur d'impulsion (154) de chacune des ondes carrées C.C. hachées triphasées (500a-500c) pour fournir une approximation d'un signal de phase sinusoïdal (604) sur chaque phase de la puissance électrique triphasée (146) fournie au moteur électrique (106) .

10. Système de surveillance des performances (101) selon l'une quelconque des revendications 1 à 9, le système de surveillance des performances (101) du moteur électrique (106) étant embarqué dans un véhicule (156) et le système de surveillance des performances (101) comprenant en outre un contrôleur de véhicule (158) en communication par signaux avec le système de surveillance de l'état de santé/des performances (112), le contrôleur de véhicule (158) étant configuré pour exécuter un ensemble de fonctions (164, 164') comprenant :
la fourniture de signaux de commande des gaz (166) au régulateur de vitesse (102) ;
l'enregistrement de données de puissance et d'efficacité (134) associées au moteur électrique (106) ;
l'enregistrement de données d'état de santé (120) associées au moteur électrique (106) ; et
l'exécution d'une action prédéterminée (136) dans le cas où des données quelconques parmi les données (120, 134) dépassent une limite prédéfinie.

11. Système de surveillance des performances (101) selon l'une quelconque des revendications 1 à 10, le véhicule étant un véhicule aérien ou un engin spatial.

12. Système de surveillance des performances (101) selon l'une quelconque des revendications 1 à 11, le système de surveillance des performances (101) étant embarqué dans un véhicule aérien (300), le véhicule aérien (300) comprenant une pluralité de systèmes d'entraînement électrique (302), chaque système d'entraînement électrique comprenant :
un moteur électrique (304) ; et
un régulateur de vitesse (306) associé à chaque moteur électrique (304), la pluralité de capteurs (312) comprenant un capteur (312) associé à chaque moteur électrique (304) et un capteur (312) associé à chaque régulateur de vitesse (306) pour mesurer les métriques de performances (110) associées à chaque moteur électrique (304) et à chaque régulateur de vitesse (306), et une sortie de chaque moteur électrique (304) étant régulée sur la base de l'efficacité de fonctionnement (118) et de l'état de santé (120) de chaque système d'entraînement électrique (302).
